# EUROPÄISCHE PATENTSCHRIFT

(11) **EP 2 031 669 B1**
(45) Veröffentlichungstag und Bekanntmachung des Hinweises auf die Patenterteilung: **14.07.2010**
(21) Anmeldenummer: 08104778.9
(22) Anmeldetag: 17.07.2008
(51) Int. Cl.: H01L 41/053, F02M 51/06, H01L 41/22

(54) **Piezoaktormodul mit einer Umhüllung des Piezoaktors und ein Verfahren zu dessen Herstellung**
Piezo actuator module having a piezo actuator sleeve and method for its manufacture
Module d'actionneur piézoélectrique comprenant une enveloppe du piézoactionneur et son procédé de fabrication

(30) Priorität: 28.08.2007 DE 102007040509
(43) Veröffentlichungstag der Anmeldung: 04.03.2009
(73) Patentinhaber: Robert Bosch GmbH, 70442 Stuttgart (DE)
(72) Erfinder: Cromme, Peter, 96050 Bamberg (DE); Pohl, Gerd, 02906 Waldhufen Thiemendorf (DE)

(56) Entgegenhaltungen:
- WO-A-01/91197
- WO-A-02/061856
- WO-A-2007/093921
- DE-A1- 10 133 151
- DE-A1- 10 310 789

## Beschreibung

### Stand der Technik

Die Erfindung betrifft ein von flüssigen Medien umströmtes Piezoaktormodul mit einer dichten Anbringung einer Umhüllung an Anbauteile bzw. am Piezoaktor, vorzugsweise zur Verwendung in einem Piezoinjektor, nach den gattungsgemäßen Merkmalen des Hauptanspruchs.

Ein solcher Piezoinjektor besteht im wesentlichen aus einem Haltekörper und dem in dem Haltekörper angeordneten Piezoaktormodul, das den zwischen einem Kopf- und Fußteil und Anbindebauteilen angeordneten Piezoaktor aus mehreren übereinandergestapelten Piezoelementen aufweist.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist eine indirekt vom Piezoaktormodul gesteuerte Düsennadel als Kraftstoffventil vorhanden, wobei der Piezoaktor eine Realisierung der Öffnungs-und Schließfunktion ermöglicht. Zur Erzielung einer optimalen Auslenkung bei minimalem Platzbedarf müssen die Innenelektroden des Piezoaktors den gesamten Querschnitt des Piezoaktors, bis auf die inaktive Kontaktierungszone, umfassen. Dies bedeutet, dass die Innenelektroden alternierender Polarität an den Seitenflachen der Keramikschichten freiliegen.

Aus diesem Grund ist eine elektrische Passivierung dieser Seitenflachen des Piezoaktors sowie die der Kontaktanbauteile zur elektrischen Passivierung des gesamten Piezoaktors notwendig, um ein Unterwandern des Piezoaktors mit den umströmenden Medien und den damit eventuell verbundenen elektrischen Überschlägen oder Kurzschlüssen zwischen benachbarten Innenelektroden zu vermeiden. Diese kann zum Beispiel durch Feuchtigkeit oder die Betriebsstoffe selbst, beispielsweise Diesel, Raps-Metylester, Wasser oder dergleichen, im Betrieb des Piezoaktors hervorgerufen werden.

Um eine elektrische und mechanische Isolierung des Piezoaktors zu erreichen, wird oft auch eine flexible Ummantelung des Piezoaktors vorgeschlagen. Aus der DE 10230032 A1 ist zur Vermeidung der zuvor beschriebenen Nachteile eine Anordnung mit einem Piezoaktormodul in umströmenden Medien bekannt, bei der die Piezoelemente in einer formveränderlichen Isolationsmasse vergossen sind, die wiederum in einem seitlich und am oberen und unteren Ende gegenüber dem Medium beispielsweise durch Schweißen verschlossenen Gehäusemantel eingebracht ist.

In der Schrift DE 103 10 789 A1 ist ein an einem Aktorfuß angeordneter piezoelektrischer Aktor offenbart, wobei der Aktorfuß Bohrungen aufweist, die zur Einbringung einer Aktorumspritzung dienen können.

In der Schrift WO 02/061856 A1 ist ein piezoelektrischer Aktor offenbart, der von einem Füllmaterial umgeben ist, das aus Polyurethan gebildet ist.

### Offenbarung der Erfindung

Die Erfindung betrifft ein Piezoaktormodul mit mindestens einem zwischen einem Aktorkopf und einem Aktorfuß eingespannten Piezoaktor und einer den Piezoaktor umgebenden Umhüllung unter Einschluss einer formveränderlichen Isolationsmasse. Es liegt gemäß der Erfindung in vorteilhafter Weise um den Piezoaktor herum und zumindest an Teilen des Aktorkopfs und/oder des Aktorfußes ein einen Hohlraum am Piezoaktor bildender Formschlauch, in dessen Hohlraum die formveränderliche Isolationsmasse über mindestens eine Öffnung im Aktorkopf und/oder im Aktorfuß eingebracht ist. Das erfindungsgemäße Piezoaktormodul ist dabei bevorzugt Bestandteil eines Piezoinjektors für ein Einspritzsystem für Kraftstoff bei einem Verbrennungsmotor, wobei der Kraftstoff unter Hochdruck die Umhüllung umströmt

Erfindungsgemäß ist der Aktorkopf und/oder der Aktorfuß derart zweigeteilt, dass ein innerer zum Piezoaktor hinweisender Teil die mindestens eine Öffnung aufweist und der zweite Teil dieses Anbindungsteils außen unter Verschluss der Öffnung nach dem Einfüllen der Isolationsmasse angefügt ist. Ein endgültige dichte Umhüllung des Piezoaktors ist gewährleistet, wenn außen auf den Formschlauch und auf angrenzende Teile des Aktorkopfs und/oder des Aktorfußes eine metallische Diffusionssperre aufgewickelt ist. Die formveränderliche Isolationsmasse ist dabei bevorzugt ein elektrisch isolierendes chemisch beständiges Elastomer oder Gel, vorzugsweise aus einem fluorierten Silikon oder Perfluorether bzw. silikonmodifiziertem Perfluorether, als mechanische Basis für die aufzuwickelnde metallische Diffusionssperre.

Bei einem vorteilhaften Verfahren zur Herstellung eines erfindungsgemäßen Piezoaktormoduls wird in einem ersten Verfahrensschritt der Formschlauch über den Piezoaktor und zumindest über Teile des Aktorkopfs und/oder der Aktorfußes gefügt, in einem zweiten Verfahrensschritt wird in den der Hohlraum zwischen dem Formschlauch und dem Piezoaktor die formveränderliche Isolationsmasse über zumindest eine Öffnung in einem Teil des Aktorkopfs und/oder des Aktorfußes eingefüllt, in einem dritten Verfahrensschritt wird die Öffnungen im Aktorkopf und/oder im Aktorfuß durch ein zweites äußeres Teil des Aktorkopfs und/oder der Aktorfußes verschlossen und in einem vierten Verfahrensschritt wird die metallische Diffusionssperre auf den Formschlauch und auf angrenzende Teile des Aktorkopfs und/oder des Aktorfußes aufgewickelt. Das Verschließen der mindestens einen Öffnung kann auf einfache Weise durch ein Aufkleben des äußeren Teils des Aktorkopfs und/oder des Aktorfußes vorgenommen werden.

Mit der Erfindung kann auf einfache Weise eine verbesserte Anbindung eines zumindest äußeren metallischen Schutzschichtsystems, bestehend aus einem Formschlauch mit einer formveränderlichen isolierenden Vergussmasse und einer äußeren metallischen Diffusionssperre an das Piezoaktormodul mit dem Piezoaktor und dem an seinen Stirnflächen angefügten Aktorkopf und dem Aktorfuß erreicht werden.

Mit dem erfindungsgemäßen Vorschlag, die Anbauteile des Piezoaktormoduls, nämlich den Aktorkopf und den Aktorfuß, entweder einzeln oder auch beide, geteilt auszuführen, kann ein einfaches Befüllen und Montieren des Formschlauchs erreicht werden, so dass eine durchgehende gleichmäßige Oberfläche für das Wickeln der metallischen Diffusionssperre hergestellt wird. Um das Füllen des Hohlraumes zu ermöglichen, ohne die Umhüllung des Piezoaktors öffnen bzw. wieder schließen zu müssen, werden Befüll- bzw. Hilfsöffnungen in den am Piezoaktor angrenzenden Teil des jeweiligen Anbauteils (Aktorkopf und/oder Aktorfuß) eingebracht. Hierzu ist es unerheblich, wie die Dichtung der Öffnungen oder deren Verschluss konstruktiv ausgeführt wird, zum Beispiel mit Dichtkanten, flächig, mit Dichtring, mit einer Kugel oder einem Kegel etc..

Je nach der Ausführung der Erfindung mit einem geteilten Anbauteil oder mit zwei geteilten Anbauteilen ist die Befüllung des Hohlraumes unter Druck steigend, durchfließend oder auch mit Vakuum unterstützt in allen Kombinationen möglich. Auch die konstruktive Ausführung der Öffnungen zur Befüllung und deren Anzahl, deren Lage oder deren Richtung, wie gerade oder schräg, kann bei dem jeweiligen Anwendungsfall auf einfache Weise optimiert werden.

### Kurze Beschreibung der Zeichnungen

Ausführungsbeispiele des erfindungsgemäßen Piezoaktormoduls werden anhand der Zeichnung erläutert. Es zeigen:
- Figur 1: einen Schnitt durch ein Piezoaktormodul mit einem Piezoaktor, einem Aktorfuß und einem Teil eines Aktorkopfes,
- Figur 2: einen Schnitt ausgehend von der Figur 1 mit einem den Piezoaktor über einen Hohlraum umhüllenden Formschlauch und mit Öffnungen im Teil des Aktorkopfes,
- Figur 3: einen Schnitt ausgehend von der Figur 1 und der Figur 2 mit einer Befüllung des Hohlraumes über die Öffnungen mit einer Isolationsmasse,
- Figur 4: einen Schnitt ausgehend von den Figuren 1 bis 3 mit einem anzufügenden zweiten Teil des Aktorkopfes zum Verschließen der Öffnungen,
- Figur 5: einen Schnitt ausgehend von den Figuren 1 bis 4 mit einem angefügten zweiten Teil des Aktorkopfes,
- Figur 6: einen Schnitt ausgehend von den Figuren 1 bis 5 mit einer auf das Piezoaktormodul aufgewickellten metallischen Diffusionssperre.

### Ausführungsformen der Erfindung

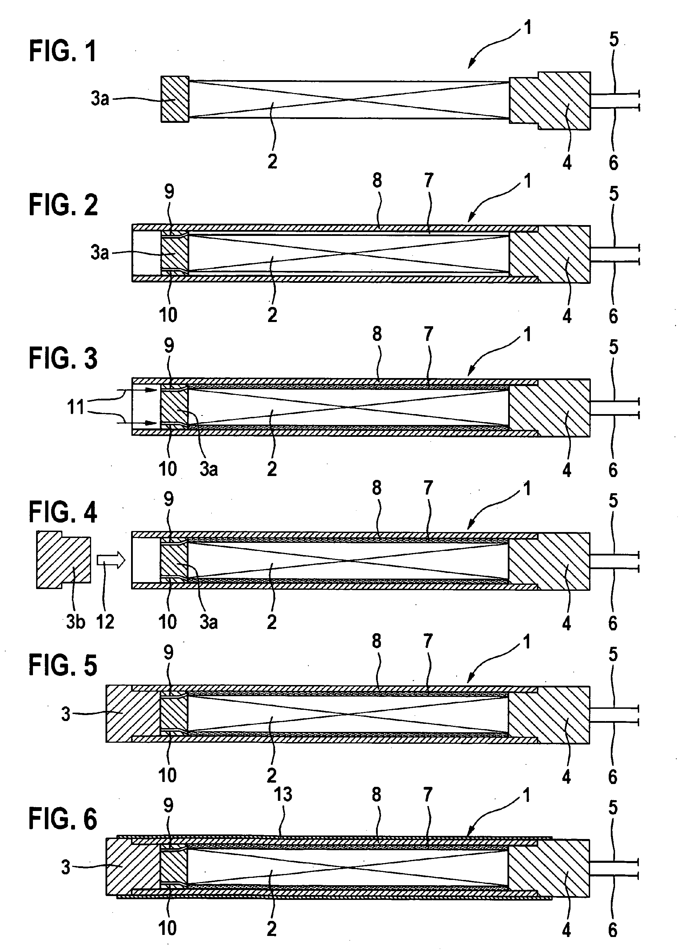

In Figur 1 ist ein Piezoaktormodul 1, beispielsweise für einen Piezoinjektor im Schnitt gezeigt, der zur Nadelhubsteuerung in einem Einspritzsystem für Kraftstoff bei einem Verbrennungsmotor eingesetzt werden kann, wie es eingangs anhand des Standes der Technik beschrieben ist.

Das Piezoaktormodul 1 weist einen Piezoaktor 2 oder eine Aneinanderreihung von mehreren solcher Piezoaktoren 2 auf, die mit den in der Beschreibungseinleitung beschriebenen Piezoelementen zur Bewirkung eines mechanischen Hubs in der Längserstreckung des Piezoaktormoduls 1 aufgebaut sind. An der linken Stirnseite des Piezoaktors 2 ist hier ein Teil 3a eines Aktorkopfes gezeigt, der weiter unten noch erläutert wird. An der rechten Stirnseite des Piezoaktors 2 ist ein Aktorfuß 4 gezeigt. Weiterhin sind hier noch elektrische Anschlüsse 5 und 6 für die Zuführung der Spannung an den Piezoaktor 2 erkennbar.

Figur 2 zeigt einen Schnitt, der ausgehend von der Figur 1 in einem nächsten Herstellungsschritt mit einem den Piezoaktor 2 über einen Hohlraum 7 umhüllenden Formschlauch 8 versehen ist. Hier sind im Teil 3a des Aktorkopfes Öffnungen 9 und 10 vorhanden, über die, wie in Figur 3 mit Pfeilen 11 angedeutet, eine formveränderliche Isolationsmasse, zum Beispiel ein Elastomer oder ein Gel, in den Hohlraum 7 zwischen dem Formschlauch 8 und dem Piezoaktor 2 eingefüllt wird.

Aus Figur 4 ist erkennbar, dass nun nach dem Befüllen des Hohlraumes 7 ein Teil 3b des Aktorkopfes 3 gemäß Pfeil 12 an das Teil 3a angefügt wird und damit die Öffnungen 9 und 10 und somit der Hohlraum 7 mit der Isolationsmasse fest verschlossen sind, wie in Figur 5 dargestellt.

Figur 6 zeigt dann den Abschluss des letzten erfindungsgemäßen Herstellungsschritts mit einer auf den Formschlauch 8 und auf Teile des Aktorkopfes 3 und des Aktorfußes 4 und somit auf das Piezoaktormodul 1 aufgewickelten metallischen Diffusionssperre 13, die einen Schutz des Piezoaktors im Inneren des Piezoaktormoduls 1 vor den äußeren an der Diffusionssperre 13 vorbeiströmenden aggressiven Medien bei einem Einsatz in einem Piezoinjektor bewirkt.

## Patentansprüche

1. Piezoaktormodul mit mindestens einem zwischen einem Aktorkopf (3) und einem Aktorfuß (4) eingespannten Piezoaktor (2) und einer den Piezoaktor (2) umgebenden Umhüllung unter Einschluss einer formveränderlichen Isolationsmasse, wobei um den Piezoaktor (2) und zumindest an Teilen des Aktorkopfs (3,3a,3b) und/oder des Aktorfußes (4) ein einen Hohlraum (7) am Piezoaktor (2) bildender Formschlauch (8) als Teil der Umhüllung liegt, in dessen Hohlraum (7) die formveränderliche Isolationsmasse über mindestens eine Öffnung (9,10) im Aktorkopf (3,3a,3b) und/oder im Aktorfuß (4) eingebracht ist, wobei der Aktorkopf (3,3a,3b) und/oder der Aktorfuß (4) derart zweigeteilt ist, dass ein innerer zum Piezoaktor (2) hinweisender Teil (3a) die mindestens eine Öffnung (9,10) aufweist und der zweite Teil (3b) außen unter Verschluss der Öffnung (9,10) nach dem Einfüllen der Isolationsmasse angefügt ist.

2. Piezoaktormodul nach Anspruch 1, **dadurch gekennzeichnet, dass** außen auf den Formschlauch (8) und auf angrenzende Teile des Aktorkopfs (3,3a,3b) und/oder des Aktorfußes (4) eine metallische Diffusionssperre (13) als weiterer Teil der Umhüllung aufgewickelt ist.

3. Piezoaktormodul nach einem der vorhergehenden Ansprüche, **dadurch gekennzeichnet, dass** die formveränderliche Isolationsmasse ein Elastomer oder ein Gel ist.

4. Piezoaktormodul nach einem der vorhergehenden Ansprüche, **dadurch gekennzeichnet, dass** das Piezoaktormodul (1) Bestandteil eines Piezoinjektors für ein Einspritzsystem für Kraftstoff bei einem Verbrennungsmotor ist, wobei der Kraftstoff unter Hochdruck die Umhüllung umströmt.

5. Verfahren zur Herstellung eines Piezoaktormoduls nach einem der vorhergehenden Ansprüche, **dadurch gekennzeichnet, dass** in einem ersten Verfahrensschritt der Formschlauch (8) über den Piezoaktor (2) und zumindest über Teile des Aktorkopfs (3,3a,3b) und/oder des Aktorfußes (4) gefügt wird, dass in einem zweiten Verfahrensschritt der Hohlraum (7) zwischen dem Formschlauch (8) und dem Piezoaktor (2) mit der formveränderlichen Isolationsmasse über die zumindest eine Öffnung (9,10) in einem Teil (3a) des Aktorkopfs (3) und/oder des Aktorfußes (4) eingefüllt wird, dass in einem dritten Verfahrensschritt die Öffnungen (9,10) im Aktorkopf (3,3a) und/oder im Aktorfuß (4) durch ein zweites äußeres Teil (3b) des Aktorkopfs (3) und/oder des Aktorfußes (4) verschlossen werden und dass in einem vierten Verfahrensschritt die metallische Diffusionssperre (13) auf den Formschlauch (8) und auf angrenzende Teile des Aktorkopfs (3,3a,3b) und/oder des Aktorfußes (4) aufgewickelt wird.

6. Verfahren nach Anspruch 6, **dadurch gekennzeichnet, dass** das Verschließen der mindestens einen Öffnung (9,10) durch ein Aufkleben des äußeren Teils (3b) des Aktorkopfs (3) und/oder des Aktorfußes (4) vorgenommen wird.

## Claims

1. Piezo-actuator module having at least one piezo-actuator (2) clamped between an actuator head (3) and an actuator base (4) and a shroud which surrounds the piezo-actuator (2) to enclose a deformable isolating material, wherein a shaped flexible tube (8), which forms a hollow space (7) on the piezo-actuator (2), lies as part of the shroud around the piezo-actuator (2) and at least on parts of the actuator head (3, 3a, 3b) and/or of the actuator base (4), the deformable isolating material being introduced into the hollow space (7) of said shaped flexible tube via at least one opening (9, 10) in the actuator head (3, 3a, 3b) and/or in the actuator base (4), wherein the actuator head (3, 3a, 3b) and/or the actuator base (4) are/is divided into two parts, in such a manner that an inner part (3a) pointing towards the piezo-actuator (2) has the at least one opening (9, 10) and the second part (3b) is attached on the outside to close the opening (9, 10) after the isolating material has been introduced.

2. Piezo-actuator module according to Claim 1, **characterized in that** a metallic diffusion barrier (13) is wound as a further part of the shroud onto the outside of the shaped flexible tube (8) and onto adjoining parts of the actuator head (3, 3a, 3b) and/or of the actuator base (4).

3. Piezo-actuator module according to either of the preceding claims, **characterized in that** the deformable isolating material is an elastomer or a gel.

4. Piezo-actuator module according to one of the preceding claims, **characterized in that** the piezo-actuator module (1) is a constituent part of a piezo-injector for a fuel injection system in an internal combustion engine, the fuel flowing around the shroud at high pressure.

5. Process for producing a piezo-actuator module according to one of the preceding claims, **characterized in that**, in a first process step, the shaped flexible tube (8) is fitted above the piezo-actuator (2) and at least above parts of the actuator head (3, 3a, 3b) and/or of the actuator base (4), **in that**, in a second process step, the hollow space (7) between the shaped flexible tube (8) and the piezo-actuator (2) is filled with the deformable isolating material via the at least one opening (9, 10) in a part (3a) of the actuator head (3) and/or of the actuator base (4), **in that**, in a third process step, the openings (9, 10) in the actuator head (3, 3a) and/or in the actuator base (4) are closed by a second, outer part (3b) of the actuator head (3) and/or of the actuator base (4), and **in that**, in a fourth process step, the metallic diffusion barrier (13) is wound onto the shaped flexible tube (8) and onto adjoining parts of the actuator head (3, 3a, 3b) and/or of the actuator base (4).

6. Process according to Claim 5, **characterized in that** the closure of the at least one opening (9, 10) is carried out by adhesively bonding the outer part (3b) of the actuator head (3) and/or of the actuator base (4).

## Revendications

1. Module d'actionneur piézoélectrique comprenant au moins un actionneur piézoélectrique (2) serré entre une tête d'actionneur (3) et une base d'actionneur (4), et une enveloppe entourant l'actionneur piézoélectrique (2) en incluant une masse isolante à forme variable, un tuyau moulé (8) formant une cavité (7) sur l'actionneur piézoélectrique (2) se situant en tant que partie de l'enveloppe autour de l'actionneur piézoélectrique (2) et au moins sur des parties de la tête d'actionneur (3, 3a, 3b) et/ou de la base d'actionneur (4), la masse isolante à forme variable étant introduite dans sa cavité (7) par le biais d'au moins une ouverture (9, 10) dans la tête d'actionneur (3, 3a, 3b) et/ou dans la base d'actionneur (4), la tête d'actionneur (3, 3a, 3b) et/ou la base d'actionneur (4) étant divisées en deux de telle sorte qu'une partie interne (3a) tournée vers l'actionneur piézoélectrique (2) présente l'au moins une ouverture (9, 10) et que la deuxième partie (3b) à l'extérieur soit assemblée en fermant l'ouverture (9, 10) après le remplissage de la masse isolante.

2. Module d'actionneur piézoélectrique selon la revendication 1, **caractérisé en ce qu'**à l'extérieur sur le tuyau moulé (8) et sur des parties adjacentes de la tête d'actionneur (3, 3a, 3b) et/ou de la base d'actionneur (4) est enroulée une barrière de diffusion métallique (13) en tant que partie supplémentaire de l'enveloppe.

3. Module d'actionneur piézoélectrique selon l'une quelconque des revendications précédentes, **caractérisé en ce que** la masse isolante à forme variable est un élastomère ou un gel.

4. Module d'actionneur piézoélectrique selon l'une quelconque des revendications précédentes, **caractérisé en ce que** le module d'actionneur piézoélectrique (1) fait partie d'un injecteur piézoélectrique pour un système d'injection de carburant dans un moteur à combustion interne, le carburant s'écoulant à haute pression autour de l'enveloppe.

5. Procédé de fabrication d'un module d'actionneur piézoélectrique selon l'une quelconque des revendications précédentes, **caractérisé en ce que** dans une première étape de procédé, le tuyau moulé (8) est assemblé sur l'actionneur piézoélectrique (2) et au moins sur des parties de la tête d'actionneur (3, 3a, 3b) et/ou de la base d'actionneur (4), **en ce que** dans une deuxième étape de procédé, la cavité (7) entre le tuyau moulé (8) et l'actionneur piézoélectrique (2) est remplie de la masse isolante à forme variable par le biais de l'au moins une ouverture (9, 10) dans une partie (3a) de la tête d'actionneur (3) et/ou de la base d'actionneur (4), **en ce que** dans une troisième étape de procédé, les ouvertures (9, 10) dans la tête d'actionneur (3, 3a) et/ou dans la base d'actionneur (4) sont fermées par une deuxième partie extérieure (3b) de la tête d'actionneur (3) et/ou de la base d'actionneur (4) et **en ce que** dans une quatrième étape de procédé, la barrière de diffusion métallique (13) est enroulée sur le tuyau moulé (8) et sur des parties adjacentes de la tête d'actionneur (3, 3a, 3b) et/ou de la base d'actionneur (4).

6. Procédé selon la revendication 5, **caractérisé en ce que** la fermeture de l'au moins une ouverture (9, 10) est effectuée par collage de la partie extérieure (3b) de la tête d'actionneur (3) et/ou de la base d'actionneur (4).
